# EUROPEAN PATENT SPECIFICATION

(11) **EP 0 520 093 B1**
(45) Date of publication and mention of the grant of the patent: **25.09.1996**
(21) Application number: 91201608.6
(22) Date of filing: 24.06.1991
(51) Int. Cl.: H04N 1/40, H03M 9/00

(54) **Parallel to serial conversion of information data**
Parallel-Serie-Umwandlung von Informationsdaten
Conversion parallèle-série de données d'information

(43) Date of publication of application: 30.12.1992
(73) Proprietor: AGFA-GEVAERT naamloze vennootschap, B-2640 Mortsel (BE)
(72) Inventor: Tack, Henri Marie, B-2650 Edegem (BE); Govaert, René Raymond, B-2950 Kapellen (BE)

(56) References cited:
- EP-A- 0 204 094
- EP-A- 0 421 712
- PATENT ABSTRACTS OF JAPAN vol. 13, no. 235 (E-766)(3583) 30 May 1989 & JP-A- 1 039 890

## Description

### Field of the invention

The present invention relates to a process for converting parallel data to a serial configuration, as applied in recording techniques e.g. in the field of thermal dye transfer printing.

### Background of the invention.

Thermal dye transfer processes have been developed to make prints from electronic pattern information signals, e.g. from pictures that have been generated electronically by means of a colour video camera. To make such prints the electronic picture can be subjected to colour separation with the aid of colour filters. The different colour selections thus obtained can then be converted into electric signals, which can be processed to form cyan, magenta, and yellow electrical signals. The resulting electrical colour signals can then be transmitted to a thermal printer. To make the print a dye-donor element having repeated separate blocks of yellow, magenta and cyan and optionally black dye is placed in face-to-face contact with a receiving sheet and the resulting sandwich is inserted between a thermal printing head and a platen roller. The thermal printing head, which is provided with a plurality of juxtaposed heat-generating resistors, can selectively supply heat to the back of the dye-donor element. For that purose it is heated up sequentially in correspondence with the cyan, magenta and yellow electrical signals, so that dye from the selectively heated regions of the dye-donor element is transferred to the receiving element and forms a pattern thereon, the shape and density of which are in accordance with the pattern and intensity of the heat supplied to the dye-donor element.

As explained before, the transfer head allows the respective heat elements to be powered in accordance with drive signals to effect thermal transfer.

The image-wise heating of the dye donor element is performed on a line-by-line basis, with the heating resistors geometrically juxtaposed each along another and with gradual (serial) construction of the output density .
But, on the contrary, the electronical image data are mostly stored in a parallel organised memory, e.g. a first-in-first-out random access memory, indicated as FIFO-RAM (or as fifo-ram ).

Therefore, a thermal dye transfer printer principally needs a conversion from the parallel input configuration to a serial output drive configuration, shortly abbreviated as P/S conversion.

All the serial data obtained by such method are fed to the driver of the transfer head and are recorded on the image-receiving receiving paper of the transfer drum.

In the European patent EP-B-0 208 919 a P/S conversion using a comparator device has been described. In this device the actual image data, with bytes consisting of 8 bits in parallel, are delivered to one input terminal of a comparator, and the sequentially incremented output of a clocked counter is fed to the second input terminal of the same comparator. The comparator output remains high, which symbolically equals to a logical 1, as long as the counter status is lower than the binary equivalent of the pixel density. As soon as the counter reaches the actual density value, the comparator reduces to low-level outgoing pulses, symbolically equal to logical 0.

In EP 0 421 712 A2 a pulse-width modulation device is disclosed as intended for use in a recording apparatus. Four-bit multivalued image data received from external equipment is loaded into a counter at the leading edge of an image clock signal. The counter is successively counted down by a clock signal outputted by a count clock generator. When the counter output becomes zero, the counter outputs a carry signal. In response, the Q-output of a J-K flip-flop is set at the leading edge of the image clock signal. This pulse-width modulated signal enters a laser driver circuit to turn a laser element on and off, thereby sensitizing a photosensitive drum so that half-tone printing may be performed using an electrographic technique.

### Objects of the invention

It is an object of the present invention to provide an alternative process and device for P/S conversion comprising a simple circuit construction, which in addition is quite cost-efficient and technically highly reliable!

Another object of the present invention is to provide a sequential pixel output that can be efficiently adapted for gradation correction by a simple construction.

A further object is to increment the flexibility in that the format of the image memory can be easily increased by cascading several RAMs in series, e.g. in the case of more line information, resulting from longer rows and/or higher spatial resolution, or by putting several RAMs in parallel, e.g. in the case of more bits pro byte, offering more density-levels.

Still further objects will become apparent from the following description and the appended claims with reference to the accompagnying drawings.

### SUMMARY OF THE INVENTION

The present invention provides a method for effecting an electronic conversion of a train of parallel configured data signals each parallel configured data signal corresponding to an image signal level of one pixel of a line of an original image to be reproduced and varying in values over a range of levels, each level differing from an adjacent level by one unit, from zero to a maximum and corresponding to density gradation variations in said pixels of said original image, into a serial configuration of signals having a single level above zero for controlling the reproduction of the original image, comprising, under controlled synchronization, the steps of :
a. Delivering said train of parallel configured data signals on a pixel by pixel basis into a line memory (43) having a capacity equal to said pixels of said at least one line,
b. Transferring said parallel configured data signals from said line memory one by one to a non-zero detector and downcounter (47) for discrimination between a zero and a non-zero level and a reduction of all non-zero levels thus discriminated by a level of one unit while the zero level signals remain at zero,
c. Outputting from said detector and downcounter (47) to a control memory a train of control signals of zero value for all data signals discriminated as zero and unity value for all data signals discriminated as non-zero while replacing the data signals present in the line memory by feeding back to the line memory the train of data signals with all non-zero level signals at the reduced level, and
d. Repeating steps b-c until all non-zero level signals have been reduced to zero.

After strobing of the latch circuit, all regrouped bits can be used e.g. to activate separate head drivers of a thermal dye transfer printer during a varying time correlating to the pixel density, all writing electrodes e.g. resistors are warming sequentially in relation with said pixel density.

More in particular, the P/S conversion method of the invention treats the line image data from the FIFO-RAM-buffer memory as a form of one line data. Each image line is questioned repetitively with a.series of d iterations of one image-input-data-level, by taking for each of said line(s) the following actions, until all binary-pixel-values reach a total zero status: detecting whether all pixel-values would be zero, downcounting each binary pixel-value by 1 level and shifting sequentially pro pixel to a latch-circuit a bit corresponding to the actual binary-value.

At the output of e.g. a thermal transfer printer, each image line is written with increments of one clock-time-unit,equivalent to one energy step. This results in increments of one partial-density level. The ultimate end-density results from the summation or integration of all writing times or cumulative partial densities.

The P/S conversion method of the present invention will be described in respect of one electrode row, forming a onedimensional array, so that heating and transfer are performed on a line-by-line basis.

However, it might also be applied in the case of electrodes coaxially juxtaposed to neighbouring line-pieces each one adjacent to another, or even to resistors geometrically displaced under different angular relationships to the thermal drum.

### Brief description of the drawings

Fig. 1 is a global block diagram illustrating an embodiment of a thermal dye transfer process, including a P/S conversion according to the present invention.

Fig. 2 is a basic diagram of a latch and strobe circuit.

Fig. 3 is a block diagram of a prior-art parallel-to-serial converter as used in thermal transfer printers.

Fig. 4 is a block diagram of a P/S converter according to the present invention.

Fig. 5 a+b are flowcharts showing the P/S conversion steps according to the present invention.

Fig. 6 is a principal embodiment of the P/S non-zero detector.

Fig. 7 is a graph illustrating the conversion of a 10-resistor-head subjected to image data of bytes consisting of 2 bits.

Fig. 8 is a curve relating the expected optical print density to the applied time modulation.

### Detailed description of preferred embodiments

Hereinbelow the present invention will be clarified in detail with reference to the attached drawings.

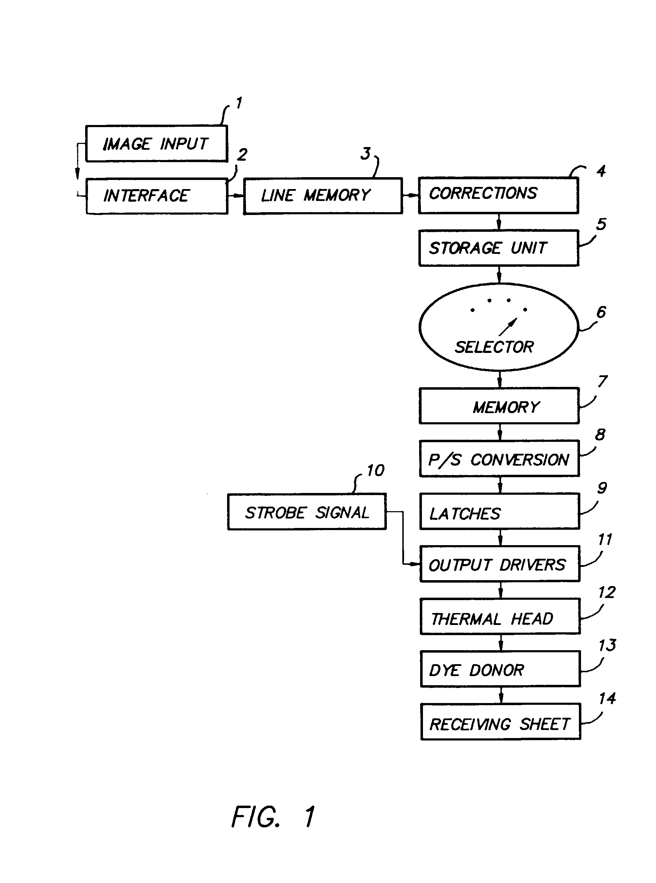

A thermal dye transfer printer including a P/S conversion according to the present invention is schematically illustrated in Fig. 1 . With reference to Fig. 1 a thermal dye transfer printing normally includes an image input 1 with interface 2, a line memory 3, several image corrections 4, a storage unit 5, a color selection switch 6, a RAM memory 7, a P/S conversion 8 , a latch and strobe circuit 9 & 10, output drivers 11, printing head 12, printing head corrections, clock synchronisation signals etc.

The data stored in the storage unit 5 are read per separate color using a switch selector 6.

After the data thus read are stored per each line of the document in the FIFO-RAM image line-memory 7, they are input to the P/S converter 8 as parallel data, after which they are converted into serial data in accordance with the method of the present invention. (and which will be explained in complete detail further on)

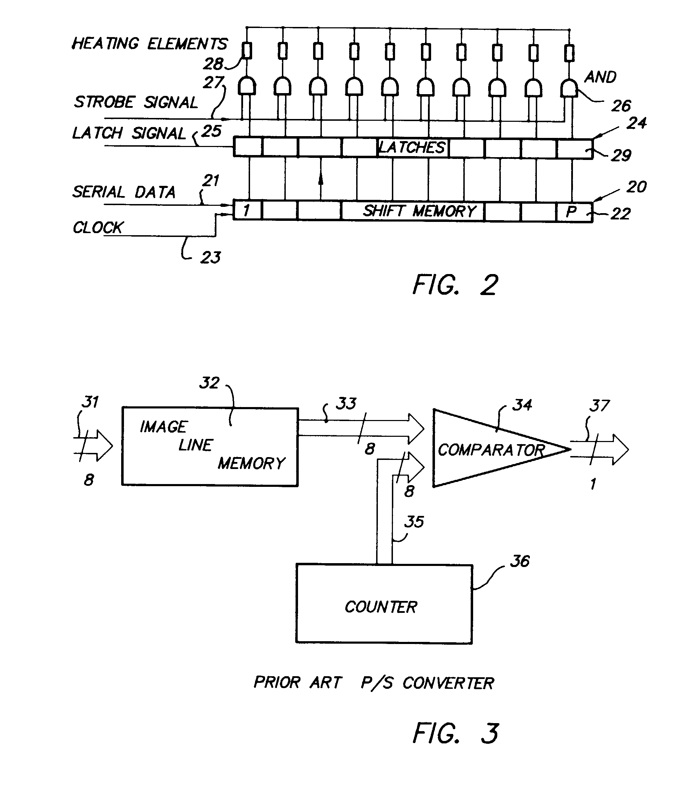

Referring to Fig. 2, the serial data 21 thus created, corresponding to p pixels and d density-levels, are delivered to a shift register, which is p bits wide, for sequentially shifting one line of serially received picture data on the basis of a clock 23 and for outputting the stored one line picture data in a geometrically parallel manner as illustrated.

As illustrated in Fig. 2 the heat-sensitive head includes a shift register supplied with serial heating data 21 from the P/S converter and producing parallel data to a latch circuit 24 for holding these data from the shift register over a 1-line-level printing period, and an AND circuit 26 connected for each bit of the latch circuit and applying to the heat-generating resistor 28 an output from the latch circuit.

These pixel data are temporarily stored by a LATCH-circuit 24 which receives and latches input trains of data representing the gradations of the image elements of the original document. Indeed, after the p bits representing a print-line have been entered in the (head-driver) shift register 22, a Latch signal 25 is supplied to activate p latches 24 so that all p bits from the shift register 22 are transferred in parrallel to the latches 24. From now on, these pixel data then are available to the appropriate logical gates, e. g. AND-elements 26. When the strobe signal 27 is given to these gates, the pixel data are delivered to the respective heat generating elements 28.

Fig. 3 illustrates a prior art P/S conversion using a comparator as described in the European patent EP-B-0 208 919. In this conversion method the actual image data 31 (e.g. bytes consisting of 8 bits in parallel) are at first stored in a line memory 32 and then delivered as one byte pro pixel to one input terminal 33 of a comparator 34. To the second input terminal 35 of the same comparator 34 is fed the sequentially incremented output of a clocked counter 36, making it possible to compare both byte-levels.

The comparator-output 37 remains high (= logical 1) as long as the counter status 35 is lower than the binary equivalent 33 of the pixel density. As soon as the counter reaches the actual pixel value, the comparator 34 switches to low level outgoing pulses (= logical 0). All the serial data 37 obtained by this method are fed, via a latch circuit, to the driver of the transfer head and are recorded on the image-receiving paper of the transfer drum.

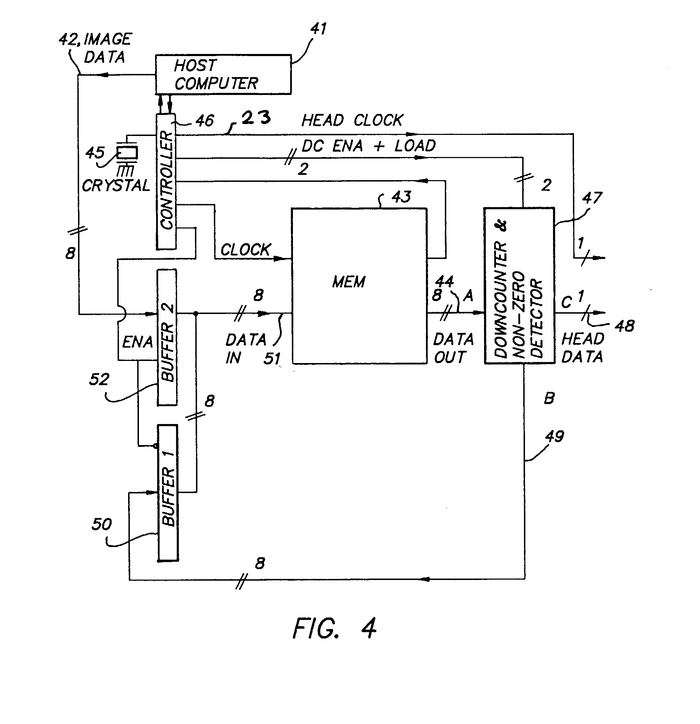

The intrinsic P/S conversion method according to the present invention will be described hereinbelow with reference to the attached drawings, especially Figs. 4 to 8.

Referring to Fig. 4, a host computer 41 provides input variable image data corresponding to one image line or eventual one line part. This data are stored in parallel in a buffered line memory designated MEM 43 and are in the form of bytes, indicated symbolically as A data 44, each byte consisting, for example, of eight parallel bits A0 - A7, indicated symbolically as Ai.

Using this example for illustration, every image data unit, representing an image pixel or dot, consists basically of eight bits, thus rendering it possible to represent each pixel with 2⁸ th levels of different image density gradiations (d) or steps or incremental units (i.e. d density variations = 256) for each color selection (color separation). In the interests of simplicity, MEM 43 is assumed to be of the FIFO (i.e. a "first-in, first-out") type but the experienced designer might occasionally employ an addressed type, i.e. RAM, for MEM 43.

In brief, the controller 46 of Fig. 4 controls, in clock synchronization, the writing in and reading ouf of image data to and from MEM 43 in four sequential steps :
1. The image data (train of bytes) for one image line is brought into the input 51 of MEM 43 via BUFFER 2.
2. Periodically, the image data of each line is transferred from MEM 43 to a downcounter and non-zero detector 47.
3. The downcounter and non-zero detector 47 and the clocking circuit for the driver components (shift register 20) of the thermal printing head are activated.
4. After downcounting (i.e. to a reduced value) and non-zero verification, output bytes 49 (at the reduced value where reduced) are ring-shifted, i.e. re-circulated, to MEM 43, via BUFFER 1.

In more detail, controller 46 is driven by a crystal 45 and at a given clockpulse, controller 46 reads out from MEM 43 all of the A data corresponding to a given first image line and transfers this A data to downcounter and non-zero detector 47.

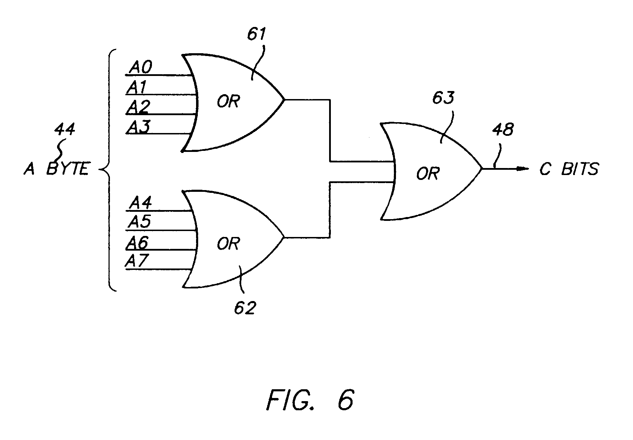

As its name reveals, the downcounter and non-zero detector performs two functions, of which the downcounting function will be explained first, with reference to Fig. 4. (A particular embodiment of non-zero detector will be explained later with special reference to Fig. 6).

Initially, all A-data are read out from MEM 43 and inspected (questioned) by the non-zero detector to ascertain whether the bytes thereof are zero or not. For each pixel a C-bit of data is outputted from the downcounter at a logic level corresponding to that of the A data and delivered to the shift register 20. That is to say, for those A-data bytes ascertained by the detector to be zero, the outputted C-bit will also be zero, but for each A-data byte greater than zero, a C-bit equal to logic 1 will be outputted. At the same time, each A-data byte (greater than one) is reduced (by the downcounter) by one incremental unit (bit), resulting in a reduced data byte B. The reduced value B-data 49 are fed back (recirculated) to the input 51 of MEM 43 and shift progressively therein.

Controller 46 restarts the reading out from MEM 43 the recalculated (now reduced value) A-data bytes in turn, i.e. beginning with the byte for the first image pixel, then the next, and so on until the last byte for the final pixel p of the given image line. The A-bytes of recalculated value are transferred from MEM 43 again to the non-zero detector and downcounter 47 and the sequence is repeated for several cycles through the steps of non-zero detection, downcounting, outputting, recirculating, and so on.

The reduction in value of A-data to B-data per cycle amounts to one incremental unit (one digital rank or bit), so that one has to expect a total of d number of cycles. The cycles end for a given image line as soon as the downcounter reaches the ultimate zero status (i.e. enough steps of re-circulation have occurred that all A bytes = zero).

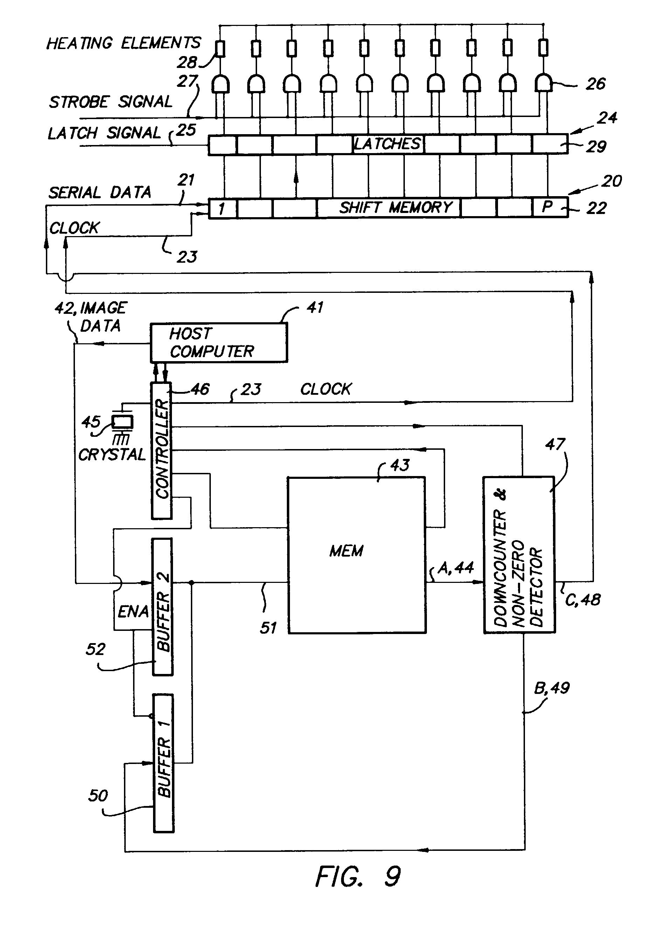

In the interests of minimizing possible confusion, the schematic diagrams of Figs. 2 and 4 have been combined into a composite diagram as Fig. 9 which gives a clearer picture of the interconnections between the two separate diagrams and thus an overall view of the actual inventive combination in a complete form.

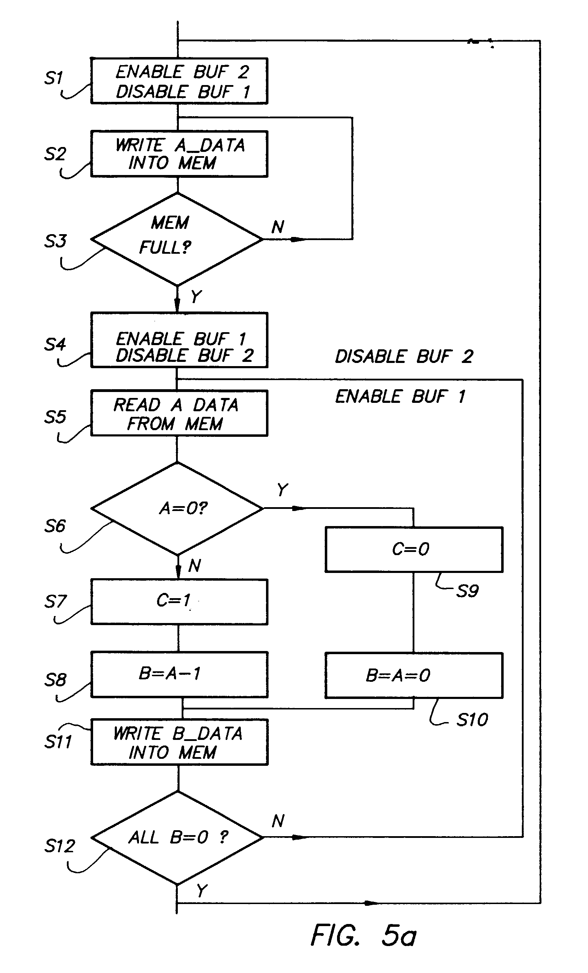

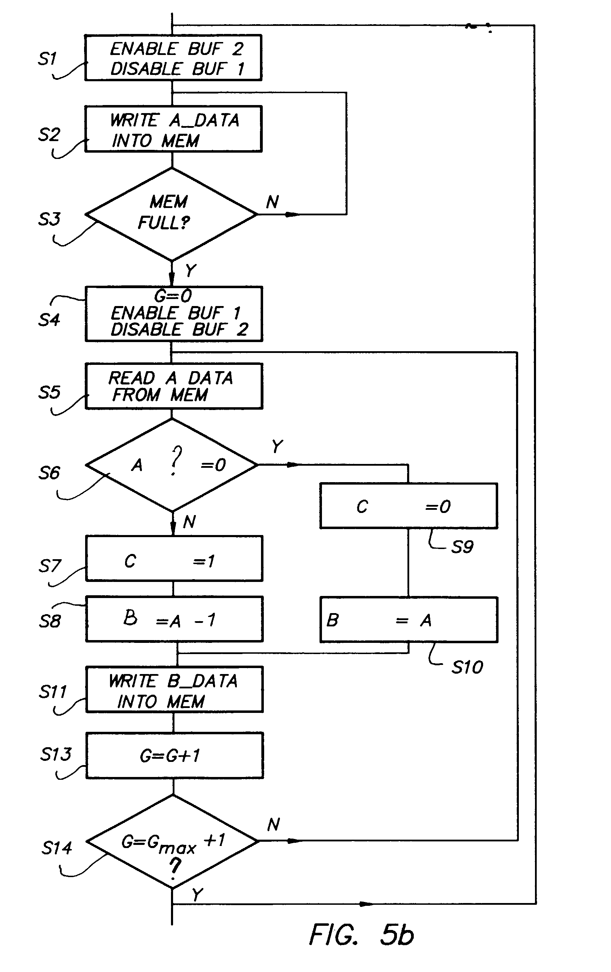

Figs. 5a and 5b are separate flow charts illustrating the separate steps in the operation of the P/S conversion method of the present invention and will now be explained. The operational sequence can begin after the image data for one image line has been stored in the line memory in preparation for a recording operation. Initially, the correct access (input) status for MEM 43 must be chosen. This is done in a firste step S 1 by disabling #2 gate buffer 52, so that in the next step S 2, all of the A-date for the given line can be written into MEM 43 via #2 gate buffer. Next, in step S 3 MEM 43 is checked to determine if it is fully loaded (i.e. whether all of the image data for the given line has been loaded successfully into the memory). (This presupposes that MEM 43 is designed with a capacity for exactly p number of pixel bytes).

At this point, the actual P/S conversion can take place. Starting with step S 4, the input to MEM 43 is disabled at # 2 gate buffer 52 and enabled at # 1 gate buffer 50. This prevents further external access to MEM 43 but opens the possibility of writing in recirculated data. At step S 5, all of the A-data are read out from MEM 43 to the downcounter and non-zero detector and in step S 6 such data are identified (verified) as to whether they are zero or non-zero. In step S 7, they are outputted as C-data in bitwise serial form to the driving components of the thermal printing head, while step S 8 executes a one-unit downcount (reduction in binary value) from A-data to B-data (i.e. wherein B = A - 1).

If by the identification in step S 6, all of the A-data are found to be zero, the sequence proceeds to step S 9 wherein all of data are outputted to the thermal printing driving components as C + 0 and recirculated as B = 0 to MEM 43. In either the case of B = 0 or B (recalculated) = (A - 1) = non-zero, step S 11 writes the B-data into MEM 43 via the #1 gate buffer 50. As soon as all B-data bytes are (eventually) found to be zero, thereby implying that all C-bits are also now zero, image data for the next image line are accepted from the host computer into MEM 43, by repeating the same sequence of operation steps.

Fig. 5b shows another embodiment of operational sequence, differing in that the one step S 12 is replaced by two steps S 13 and S 14.

As regards the difference between the two embodiments of Figs. 5A and 5B, in the Fig. 5A embodiment, for a given range of density levels (= d) in the image, the "downcounting" proceeds over the entire number of levels d. Contrarywise, in the Fig. 5B embodiment for an image characterized by the same range of density levels d, some maximum level "G max" is selected at which point the downcounting is arbitrarily discontinued rather than taking the downcounting to the ultimate limit d. In this way, the overall procedure is shortened by a number of iterations equal to the difference between d and G max although the resolution of the final image may be somewhat degraded, dependent upon the magnitude of that difference.
The main differences between Fig. 5a and Fig. 5b thus reflect in the last step of the P/S conversion method according to the invention.A method according to Fig. 5a ends as all non-zero levels have been reduced to zero. A method according to Fig. 5b ends as a maximum level G max, corresponding to a maximum density gradation variation in the original image or corresponding to a preset level, has been transferred and downcounted.
Suppose, for example, a system in which 2⁸ levels of different image density gradations (thus d = 256) could be represented. If in a particular image e.g. only 105 (being Gmax) density gradations would be present, according to Fig. 5a the P/S conversion would stop after 256 iterations, whereas according to Fig. 5b the P/S conversion would stop after 105 iterations.
Now, some additional advantages also may become more clear. A method according to Fig. 5b substantially has a higher throughput and thus saves time (= more economics in use), whereas a method according to Fig. 5a substantially has a less complicated circuitry, a standard throughput and a standard quality (as no speed changes of the image receiving sheet are included).

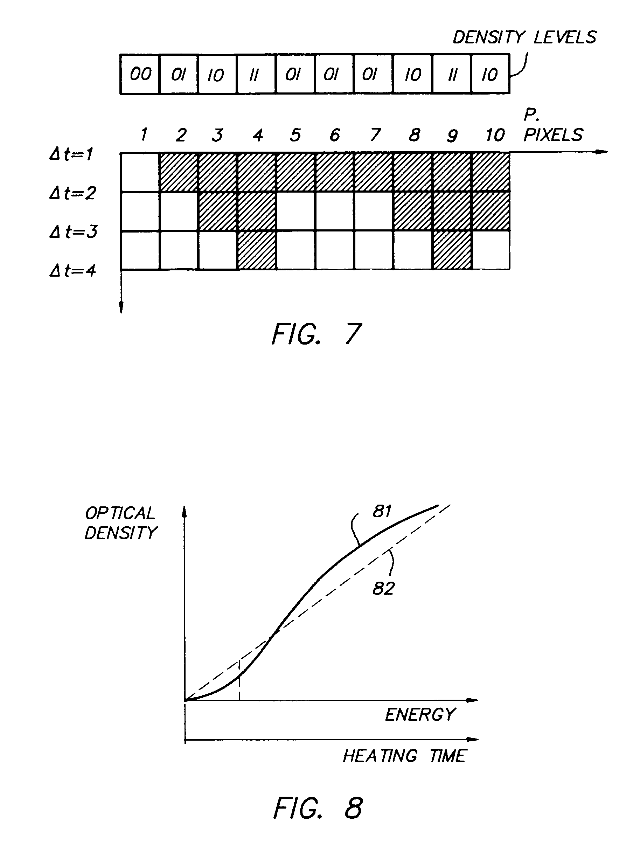

In the case where for each pixel, the reduced B byte data read out of the downcounter is not zero, signifying that at least one bit of a B byte is a logic one, a signal C equal to a logic one bit is outputted from the downcounter to the shift register and thence to the latching memory circuit when the latter is activated. Enablement (strobing) of the latching memory circuit results in the application of a signal to the corresponding heating element of the thermal printing head for exactly one time unit which in turn results in the transfer to the receiving sheet of "one unit" of dye, equal to one density gradation level (one density step) of the image pixels. (The transfer of additional "units" of dye for the same pixel will be explained in connection with Fig. 7).

For the particular case where each image byte has eight bits, as mentioned above, there is a possibility, as already noted, of 256 density gradation steps or levels. Thus, the existence of eight bit data per byte allows a total of 256 time units per heating element. As a general rule, for d number of density levels or steps to be differentiated, resulting from Antilog2 (d) bits, the reading/recalculating/non zero detecting cycle would be repeated exactly d number of times.

After completion of heat generation by the heating elements up to the last of the density gradation levels d, the printing of the initial line is terminated and the image data for the next line is applied to the line memory in preparation for printing of the next line.

There will now be described in conjunction with the A-data in step S6 (but which also applies to the B-data in step 12) the operation of a non-zero detection circuit, constituted of simple OR-gates 61, 62, and 63, as seen in Fig. 6. Here, if the gate for a given pixel is read as zero, signifying that all of the bits Ai of the corresponding byte of image data are at logic zero, then a C-bit 48 equal to logic zero is outputted to the corresponding driving components of the thermal printing head which precludes any transfer of dye by the corresponding heating element.

With continued reference to Fig. 6, which shows a non-zero detector for bytes each having eight bits and which uses OR-gates, the logic for controlling the thermal printing head can be formulated as C = A0 + A1 + A2 + ..... A7.

It will be clear to one skilled in the art that a downcounter could be built of discrete components as well as with gate array logics (e.g. gal, pal). Alternatively, the downcounter could be based on commercial components with integrated zero-detector. Further, if appropriate controls were provided, a different format for the data bytes (8, 10 or 12 bits per byte) would be handled.

The thermal printing head normally includes a plurality of heating elements equal in number to the number of pixels in the image data present in the line memory. Remembering that each of these heating elements is capable of being energized individually by heating pulses and that the number of heating pulses for each heating element is controlled in accordance with the density gradation level of the corresponding pixel, Fig. 7 illustrates the heating pulse pattern for a ten element head for the simplified case where the number of pixels p equals ten and each pixel is represented by a signal byte having two bits (corresponding to a range of four density gradation levels or steps). Thus, in this case, zero density is represent by a bit logic of zero/zero, the first density step by a bit logic of zero/one, the second density step by a bit logic of one/zero, and the final density step by a bit logic of one/one.

With reference to Fig. 7 (where the pixels (p = 10) are indicated numerically as well as by their logic levels, i.e. bit 1 = 0,1; bit 2 = 0,1), it follows from the foregoing explanation that the application of the (recordation) pulses to the heating elements of the printing head - after the latching memory circuit has been enabled - causes current to flow through the corresponding individual heating elements, resulting in a pattern wherein the number of heating steps is represented by At and the effect for each pixel heated during a given step are represented by the "black (hatched) squares" and for each pixel not heated during a step by the "white squares" in Fig. 7.

The overall pulse duration (width) - resulting from the integration of the number of individual pulses for a given heating element - will determine the total heating (recording) energy for a given heating element in a given image line.

As the density for a given image pixel increases, the heating time of the corresponding heating element will increase proportionally, thereby increasing the heat energy outputted by that element and thus increasing the heat energy outputted by that element and thus increasing the optical density of the dye transferred to the receiving sheet for that pixel. Contrarywise, where an image pixel data has a lower density level, the heating time is shortened and the corresponding "picture data" on the receiving sheet is lighter in density.

This relationship is shown graphically in Fig. 8 wherein a natural/normal density curve for a typical image is represented by the solid line 81 and a linear approximation of that curve is represented by a broken line 82.

According to a further preferred embodiment applied in the field of thermal dye transfer printing, the method of manipulating a train of parallel configured electrical signals, each of said parallel configured electrical signals corresponding to a pixel of a line of an original image, equal in value to the density gradation levels of a plurality of image pixels of an original image over a range of density gradation levels from zero to a maximum for controlling the reproduction of the original image on a receiving medium in a thermal printer having an array of controllable printing elements corresponding in number to the pixels in an image line and an actuating circuit for actuating the respective printing elements in individually accessible fashion, comprises, under controlled synchronization, the steps of:
a. Storing on a pixel by pixel basis said train of signals for a given line of image pixels in a line memory 43 via an input thereto,
b. Transferring said signals one by one from the line memory to a detector and downcounter 47 for discriminating between a zero value signal and any non-zero signal and for downcounting of all non-zero value signals to reduce the corresponding density gradation level thereof by one level,
c. Outputting from said detector and downcounter for each signal inputted thereto a control signal to the printer actuating circuit, said control signal being a printing signal for each non-zero value signal and a non-printing signal for each zero value signal, said control signal having a duration of one time unit which is selected to equal a reproduction by said thermal printer on said receiving medium of an image having one density gradation level,
d. Actuating the printing elements by the actuating circuit thereof in correspondence with said control signals said one time period,
e. Replacing the electrical signals in said line memory by returning to the input of said line memory the zero value and value-reduced non-zero signals from the detector and downcounter for transfer again to said non-zero detector and downcounter, and
f. Repeating steps b. - e. for a total number of cycles necessary for all non-zero signal values to be reduced to zero, whereby the printing elements of said printer are actuated for a number of time periods equal to the total number of cycles to reproduce on said receiving sheet images of said pixels of said original image varying in density in correspondence with the density variations of the pixels of said original image.

Although the exemplary P/S conversion circuit shown in Fig. 4 included only a single memory MEM and a single downcounter and non-zero detector, the capacity of the circuit for more density levels could easily be extended (by connecting more MEM's in parallel) or for more information per line (by connecting more MEM's in series).
Depending on the exact configuration of the host computer and of the internal memory MEM, the image data could be stored entirely in the host computer and transferred line-by-line in sequence to the MEM, as was taken to be the case in the example described above, or they could be shifted to an addressed MEM with a capacity large enough for all the line data of a given color of a given image.

In any event, for each case, the actual electronic circuit has to be completed by some additional components not shown but such components would be obvious to those knowledgeable in the art and their omission does not degrade an understanding of the inventive concept conveyed by the exemplary circuits.

The present invention can be applied to any type of thermal recording, including the type in which image data are thermally recorded directly on a thermal recording paper, and the type in which data are thermally transferred onto ordinary paper. The printing is not limited to the above-explained method employing a thermal head, but can also be applied by other technologies as resistive ribbon printing, dye diffusion resistor ribbon, ink-jet printing. Also the recording medium is not limited to a recording paper, but might be a textile or a plastic or a transparant for overhead projection.

## Claims

1. A method of effecting an electronic conversion of a train of parallel configured data signals (42), each parallel configured data signal corresponding to an image signal level of one pixel of a line of an original image to be reproduced and varying in values over a range of levels, each level differing from an adjacent level by one unit, from zero to a maximum and corresponding to density gradation variations in said pixels of said original image, into a serial configuration of signals (21) having a single level above zero for controlling the reproduction of the original image, by delivering said train of parallel configured data signals on a pixel by pixel basis into a line memory (43) having a capacity equal to said pixels of said at least one line, the method being characterized in that it further comprises, under controlled synchronization, the steps of :
a. Transferring said parallel configured data signals from said line memory one by one to a non-zero detector and downcounter (47) for discrimination between a zero and a non-zero level and a reduction of all non-zero levels thus discriminated by a level of one unit while the zero level signals remain at zero,
b. Outputting from said detector and downcounter (47) to a control memory a train of control signals (48) of zero value for all data signals discriminated as zero and unity value for all data signals discriminated as non-zero while replacing the data signals present in the line memory (43) by feeding back to the line memory the train of data signals with all non-zero level signals at the reduced level, and
c. Repeating steps a-b until all non-zero level signals have been reduced to zero.

2. A method according to claim 1 wherein said line memory (43) is a first-in-first-out memory FIFO or a randomly addressable memory RAM.

3. A method according to claim 1 wherein said control memory comprises a shift register (20) and an associated latching memory circuit (24) which are adapted to be actuated to receive and store the control signals in sequence and deliver the control signals.

4. A method according to claim 3 wherein said original is to be reproduced by means of a thermal printer which includes a number of printing elements (28) operable to generate a reproduction and said control signals are applied by said latching memory circuit (24) on said signal to said printing elements to operate the same.

5. A method according to claim 1 or 4, wherein each of said parallel configured electrical data signals corresponding to a pixel of a line of an original image, equals in value to a density gradation level of a plurality of image pixels of an original image over a range of density gradation levels from zero to a maximum for controlling the reproduction of the original image on a receiving medium in a thermal printer having controllable printing elements corresponding in number to the pixels in an image line and an actuating circuit for actuating the respective printing elements in individually accessible fashion.

6. A method according to claim 5, wherein step c is replaced by the steps of:
c. Actuating the printing elements of said thermal printer by the actuating circuit in correspondence with said control signals having each a duration of one time unit which is selected to equal a reproduction by said thermal printer on said receiving medium of an image having one density gradation level,
d. said feeding back comprising replacing the electrical signals in said line memory by returning to the input of said line memory the zero value and value-reduced non-zero signals from the detector and downcounter for transfer again to said non-zero detector and downcounter, and
e. Repeating steps a. - d. for a total number of cycles necessary for all non-zero signal values to be reduced to zero, whereby the printing elements of said printer are actuated for a number of time periods equal to the total number of cycles to reproduce on said receiving sheet images of said pixels of said original image line varying in density in correspondence with the density variations of the pixels of said original image.

7. The method of claim 6 wherein said train of electrical signals represents a single line of a pixel of a single color derived from a multi-color original.

8. The method of claim 7 wherein said multi-color original contains magenta, cyan, and yellow, and optionally black, colors, and the pixels represented by said signals are of one of said colors.

## Patentansprüche

1. Verfahren zum Bewirken einer elektronischen Umsetzung einer Serie parallel angeordneter Datensignale (42), wobei jedes parallel angeordnete Datensignal einem Bildsignalpegel eines Bildpunkts einer Zeile eines wiederzugebenden Originalbildes entspricht und wertemäßig über einen Bereich von Pegeln von Null bis zu einem Maximum variiert, wobei jeder Pegel sich vom benachbarten Pegel um eine Einheit unterscheidet, und Dichteabstufungsschwankungen in den Bildpunkten in dem Originalbild entspricht, in eine serielle Anordnung von Signalen (21) mit einem Einzelpegel über Null, um die Wiedergabe des Originalbildes zu steuern, indem die Serie parallel angeordneter Datensignale bildpunktweise in einen Zeilenspeicher (43) mit einer Kapazität geliefert wird, die den Bildpunkten der besagten mindestens einen Zeile entspricht, wobei das Verfahren dadurch gekennzeichnet ist, daß es weiterhin die folgenden Schritte unter gesteuerter Synchronisierung umfaßt:
a. Übertragen der parallel angeordneten Datensignale von dem Zeilenspeicher eins nach dem anderen zu einem Nichtnulldetektor und Rückwärtszähler (47) zur Unterscheidung zwischen einem Pegel Null und einem von Null verschiedenen Pegel und zur Reduzierung aller so unterschiedener, von Null verschiedener Pegel um einen Pegel einer Einheit, während die Signale mit Nullpegel bei Null bleiben;
b. Abgabe an einen Steuerspeicher, vom Detektor und Rückwärtszähler (47), einer Serie von Steuersignalen (48) mit Wert Null für alle als Null unterschiedenen Datensignale und mit Wert Eins für alle als nicht Null unterschiedenen Datensignale, wobei die im Zeilenspeicher (43) vorhandenen Datensignale ersetzt werden, indem die Serie von Datensignalen mit Signalen mit nur einem von Null verschiedenen Pegel mit dem reduziertem Pegel an den Zeilenspeicher zurückgeführt wird, und
c. Wiederholen der Schritte a-b so lange, bis alle Signale mit einem von Null verschiedenen Pegel auf Null reduziert worden sind.

2. Verfahren nach Anspruch 1, wobei es sich bei dem Zeilenspeicher (43) um einen Durchlaufspeicher FIFO oder um einen Speicher RAM, auf den wahlweise zugegriffen werden kann, handelt.

3. Verfahren nach Anspruch 1, wobei der Steuerspeicher ein Schieberegister (20) und eine zugeordnete Haltespeicherschaltung (24) umfaßt, die betätigt werden können, um die Steuersignale nacheinander zu empfangen und zu speichern und die Steuersignale zuzuführen.

4. Verfahren nach Anspruch 3, wobei das Original mit Hilfe eines Thermodruckers wiedergegeben werden soll, der eine Anzahl von Druckelementen (28) enthält, die betätigt werden können, um eine Wiedergabe zu erzeugen, und die Steuersignale durch die Haltespeicherschaltung (24) beim besagten Signal zu den Druckelementen angelegt werden, um die Druckelemente zu betätigen.

5. Verfahren nach Anspruch 1 oder 4, wobei jedes der einem Bildpunkt einer Zeile eines Originalbildes entsprechenden parallel angeordneten elektrischen Datensignale wertemäßig einem Dichteabstufungsgrad mehrerer Bildpunkte eines Originalbilds über einen Umfang von Dichteabstufungsgraden von Null bis zu einem Maximum entspricht, um die Wiedergabe des Originalbildes auf einem Empfangsmedium in einem Thermodrucker zu steuern, der steuerbare Druckelemente, die zahlenmäßig den Bildpunkten in einer Bildzeile entsprechen, und eine Betätigungsschaltung zum Betätigen der jeweiligen Druckelemente auf individuell zugängliche Weise aufweist.

6. Verfahren nach Anspruch 5, wobei Schritt c durch folgende Schritte ersetzt wird:
c. Betätigen der Druckelemente des Thermodruckers durch die Betätigungsschaltung gemäß den Steuersignalen, die jeweils eine Dauer von einer Zeiteinheit aufweisen, die so ausgewählt ist, daß sie einer Wiedergabe eines Bildes mit einem Dichteabstufungsgrad durch den Thermodrucker auf dem Empfangsmedium entspricht,
d. wobei das Rückführen das Ersetzen der elektrischen Signale in dem Zeilenspeicher umfaßt, indem die Nullwert- und wertemäßig reduzierten Nichtnullsignale von dem Detektor und Rückwärtszähler zur erneuten Übertragung zu dem Nichtnulldetektor und Rückwärtszähler zu dem Eingang des Zeilenspeichers zurückgeführt werden, und
e. Wiederholen der Schritte a.- d. während einer Gesamtzahl von Zyklen, die zur Reduzierung aller Nichtnullsignalwerte auf Null erforderlich ist, wodurch die Druckelemente des Druckers für eine Anzahl von Zeitdauern betätigt werden, die gleich der Gesamtzahl von Zyklen ist, um dichtemäßig gemäß den Dichteschwankungen der Bildpunkte des Originalbilds schwankende Abbilder der Bildpunkte der Originalbildzeile auf dem Empfangsbogen wiederzugeben.

7. Verfahren nach Anspruch 6, wobei die Serie elektrischer Signale eine einzelne Zeile eines Bildpunkts einer einzelnen, aus einer Vielfarbvorlage abgeleiteten Farbe darstellt.

8. Verfahren nach Anspruch 7, wobei das Vielfarboriginal die Farben Magenta, Cyan und Gelb, und wahlweise Schwarz, enthält, und die durch die Signale dargestellten Bildpunkte eine der Farben aufweisen.

## Revendications

1. Procédé de réalisation d'une conversion électronique d'un train de signaux de données configurés parallèlement (42), chaque signal de données configuré parallèlement correspondant à un niveau de signal d'image d'un pixel d'une ligne d'une image d'origine à reproduire et variant en valeurs sur une gamme de niveaux, chaque niveau différant d'un niveau adjacent par une unité, de zéro à un maximum et correspondant à des variations de gradation de densité dans lesdits pixels de ladite image d'origine, en une configuration série de signaux (21) ayant un niveau unique au-dessus de zéro pour commander la reproduction de l'image d'origine en fournissant ledit train de signaux de données configurés parallèlement pixel par pixel dans une mémoire de lignes (43) ayant une capacité égale auxdits pixels de ladite au moins une ligne, le procédé étant caractérisé en ce qu'il comprend en outre, dans le cadre d'une synchronisation contrôlée, les étapes de:
a. Transfert desdits signaux de données configurés parallèlement depuis la mémoire de lignes un à un vers un détecteur de valeur non nulle et décompteur (47) en vue d'une discrimination entre un niveau nul et un niveau non nul et d'une réduction de tous les niveaux non nuls ainsi discriminés par un niveau d'une unité tandis que les signaux de niveau nul restent à zéro,
b. Production à partir dudit détecteur et décompteur (47) vers une mémoire de commande d'un train de signaux de commande (48) d'une valeur nulle pour tous les signaux de données discriminés comme étant nuls et d'une valeur d'unité pour tous les signaux de données discriminés comme non nuls tout en remplaçant les signaux de données présents dans la mémoire de lignes (43) par renvoi dans la mémoire de lignes du train de signaux de données aux signaux ayant tous un niveau non nul au niveau réduit, et
c. Répétition des étapes a.-b. jusqu'à ce que tous les signaux de niveau non nul aient été réduits à zéro.

2. Procédé conformément à la revendication 1, dans lequel ladite mémoire de ligne (43) est une mémoire premier entré, premier sorti FIFO ou une mémoire vive RAM.

3. Procédé conformément à la revendication 1, dans lequel ladite mémoire de commande comprend un registre à décalage (20) et un circuit de mémoire de verrouillage associé (24) qui sont adaptés en vue d'être actionnés pour recevoir et stocker les signaux de commande en séquence et fournir les signaux de commande.

4. Procédé conformément à la revendication 3, dans lequel ledit original doit être reproduit au moyen d'une imprimante thermique qui comporte un certain nombre d'éléments d'impression (28) actionnables pour générer une reproduction et lesdits signaux de commande sont appliqués par ledit circuit de mémoire de verrouillage (24) sur ledit signal auxdits éléments d'impression pour actionner ceux-ci.

5. Procédé conformément à la revendication 1 ou 4, dans lequel chacun desdits signaux de données électriques configurés parallèlement correspondant à un pixel d'une ligne d'une image d'origine, est égal en valeur à un niveau de gradation de densité d'une pluralité de pixels d'image d'une image d'origine sur une gamme de niveaux de gradation de densité allant de zéro à un maximum pour commander la reproduction de l'image d'origine sur un moyen récepteur dans une imprimante thermique ayant des éléments d'impression contrôlables correspondant en nombre aux pixels dans une ligne d'image et un circuit d'actionnement pour actionner les éléments d'impression respectifs de manière accessible individuellement.

6. Procédé conformément à la revendication 5, dans lequel l'étape c est remplacée par les étapes de:
c. Actionnement des éléments d'impression de ladite imprimante thermique par le circuit d'actionnement en correspondance avec lesdits signaux de commande ayant chacun une durée d'une unité de temps qui est sélectionnée pour être égale à une reproduction par ladite imprimante thermique sur ledit moyen récepteur d'une image ayant un niveau de gradation de densité,
d. Ledit renvoi comprenant le remplacement des signaux électriques dans ladite mémoire de lignes en renvoyant à l'entrée de ladite mémoire de lignes les signaux de valeur nulle et les signaux de valeur réduite non nulle provenant du détecteur et décompteur pour le transfert une nouvelle fois audit détecteur de valeur non nulle et décompteur, et
e. Répétition des étapes a. à d. pour un nombre total de cycles nécessaire pour que toutes les valeurs de signaux non nulles soient réduites à zéro, de telle sorte que les éléments d'impression de ladite imprimante soient actionnés pendant un certain nombre de périodes de temps égal au nombre total de cycles pour reproduire sur ladite feuille réceptrice les images desdits pixels de ladite ligne d'image d'origine variant en densité en correspondance avec les variations de densité des pixels de ladite image d'origine.

7. Procédé de la revendication 6, dans lequel ledit train de signaux électriques représente une ligne unique d'un pixel d'une seule couleur dérivée d'un original multicolore.

8. Procédé de la revendication 7, dans lequel ledit original multicolore contient les couleurs magenta, cyan et jaune, et facultativement noire, et les pixels représentés par lesdits signaux sont de l'une desdites couleurs.
